# EUROPÄISCHE PATENTSCHRIFT

(11) **EP 0 833 451 B1**
(45) Veröffentlichungstag und Bekanntmachung des Hinweises auf die Patenterteilung: **04.08.2004**
(21) Anmeldenummer: 97115362.2
(22) Anmeldetag: 04.09.1997
(51) Int. Cl.: H03K 19/096, H03K 19/017, G06F 9/38

(54) **Schaltungsanordnung mit zwischen Registern angeordneten kombinatorischen Blöcken**
Circuit comprising combinatory logic blocks between registers
Circuit comportant des blocs combinatoires entres des registres

(30) Priorität: 27.09.1996 DE 19639937
(43) Veröffentlichungstag der Anmeldung: 01.04.1998
(73) Patentinhaber: Infineon Technologies AG, 81669 München (DE)
(72) Erfinder: Ecker, Wolfgang, 81377 München (DE)
(74) Vertreter: Lange, Thomas, Dr.

(56) Entgegenhaltungen:
- EP-A- 0 703 530
- US-A- 4 039 858
- US-A- 5 572 479
- P. M. KOGGE: "The Architecture of Pipelined Computers" 1981 , MCGRAW-HILL , NEW YORK, US XP002112765 13286 * Seite 21 - Seite 33 *

## Beschreibung

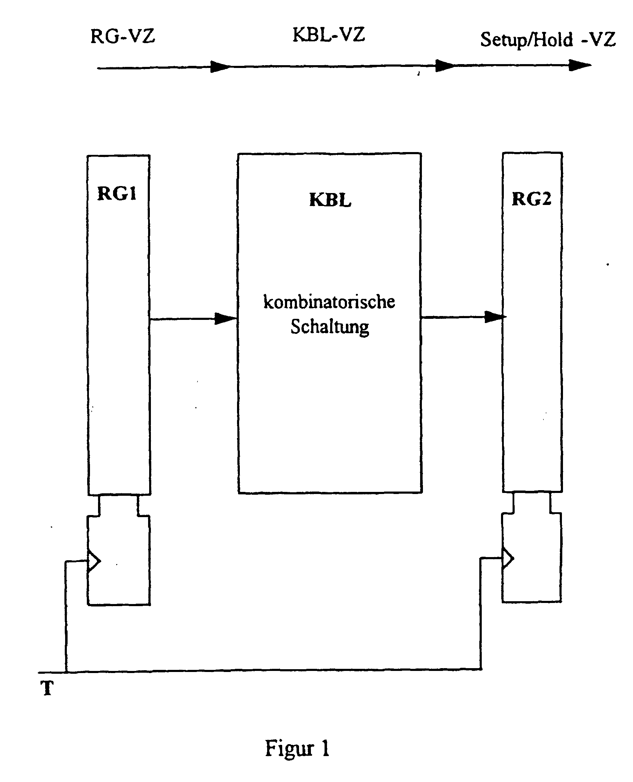

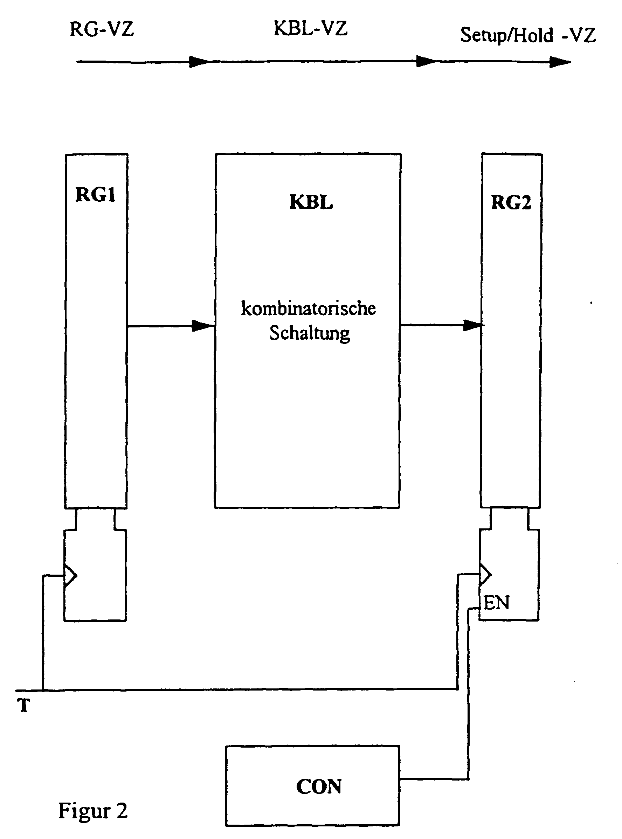

Bei der Entwicklung von synchronen Schaltungen liegen zwischen Registern (im folgenden beispielsweise Eingangsregister RG1 und Ausgangsregister RG2 genannt) immer sogenannte kombinatorische Blöcke KBL (auch kombinatorische Schaltung genannt, s. Fig. 1, 2). Um die physikalisch bedingten Setupund Hold-Zeiten einzuhalten, gibt es heutzutage drei Prinzipien kombinatorische Blöcke und Register anzuordnen:
- Die Laufzeit/Verzögerungszeit KBL-VZ von Wertänderungen durch die kombinatorischen Blöcke KBL ist kleiner als die Taktperiode minus der Setup-Zeit Setup/Hold-VZ und minus der Signallaufzeit RG-VZ durch ein Register RG. Dies ist in Figur 1 dargestellt. Zwischen ein Eingangsregister RG1 und Ausgangsregister RG2 ist ein kombinatorischer Block KBL geschaltet. Die Register RG1 und RG2 werden mit einem Taktsignal T angesteuert.
- Die Laufzeit von Wertänderungen durch die kombinatorischen Blöcke KBL ist um einen Faktor N größer als eine Taktperiode des Taktsignales T. Das Ergebnis wird aber erst N Taktsignale später am Ausgang des Ausgangsregisters RG2 nach den kombinatorischen Blöcken KBL abgegriffen.
- Die Laufzeit von Wertänderungen durch die kombinatorischen Blöcke KBL ist um einen Faktor N größer als eine Taktperiode des Taktsignales T. Das Ergebnis wird aber erst N Taktsignale später in das Ausgangsregister RG2 nach den kombinatorischen Blöcken KBL eingespeichert. Dazu wird ein Enable-Anschluß EN an dem Ausgangsregister RG2 mit einem um N-Taktsignale verzögerten Impuls, erzeugt durch eine Steuerschaltung CON, angesteuert. Dies ist in Figur 2 zu sehen.

Die Laufzeit einer kombinatorischen Schaltung KBL ist dahingehend ausgelegt, daß immer die letzt möglichen Signalwertänderungen an ihren Ausgängen die Laufzeit bestimmen. Dabei wird davon ausgegangen, daß im Betrieb auch immer diese Fälle eintreten.

Ändern sich aber bestimte Eingangssignale einer kombinatorischen Schaltung nicht, dann müßte deren Effekt auf die Laufzeit nicht berücksichtigt werden. Handelt es sich bei den Eingangssignalen um solche, die die Laufzeit einer kombinatorischen Schaltung bestimmen, dann verringert sich in diesem Fall die Laufzeit duch die kombinatorische Schaltung.

Aus p.h. Kogge "The Architecture of Pipelined Computers", 1981, Mc Graw-Hill, New-York, Chapter II ist eine Schaltungsanordnung mit kombinatorischen Blöcken bekannt, bei der deren Ausgangssignale an hinter die kombinatorischen Blöcke geschaltete Ausgangsregister abgegeben werden.

Ferner ist aus der europäischen Patentanmeldung EP 04 56 399 A2 eine Schaltung mit kombinatorischen Blöcken und Speichereinheiten bekannt.

Die der Erfindung zugrunde liegende Aufgabe besteht darin, den obengenannten Effekt auszunutzen und ereignisabhängig Werte am Ausgang einer kombinatorischen Schaltung abzugreifen.
Diese Aufgabe wird gemäß den Merkmalen des Patentanspruches 1 gelöst.

Weiterbildungen der Erfindung ergeben sich aus den abhängigen Ansprüchen.

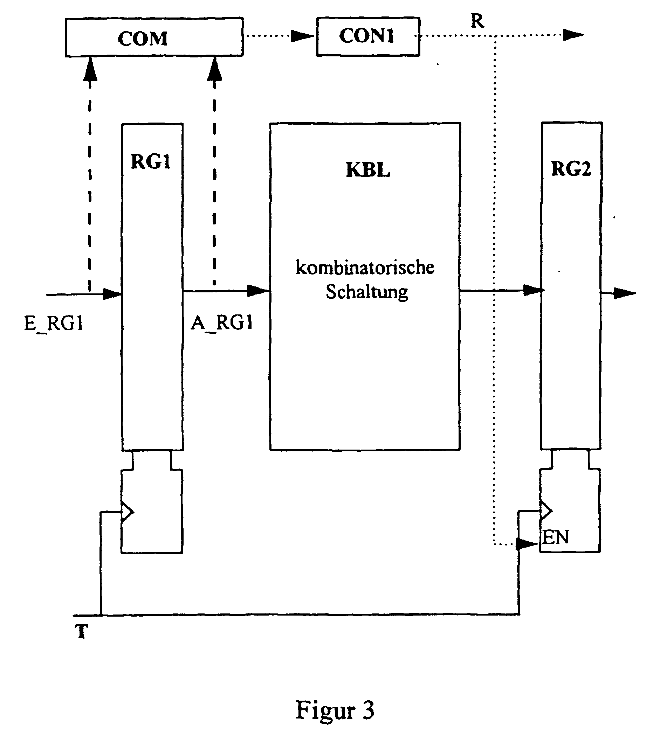

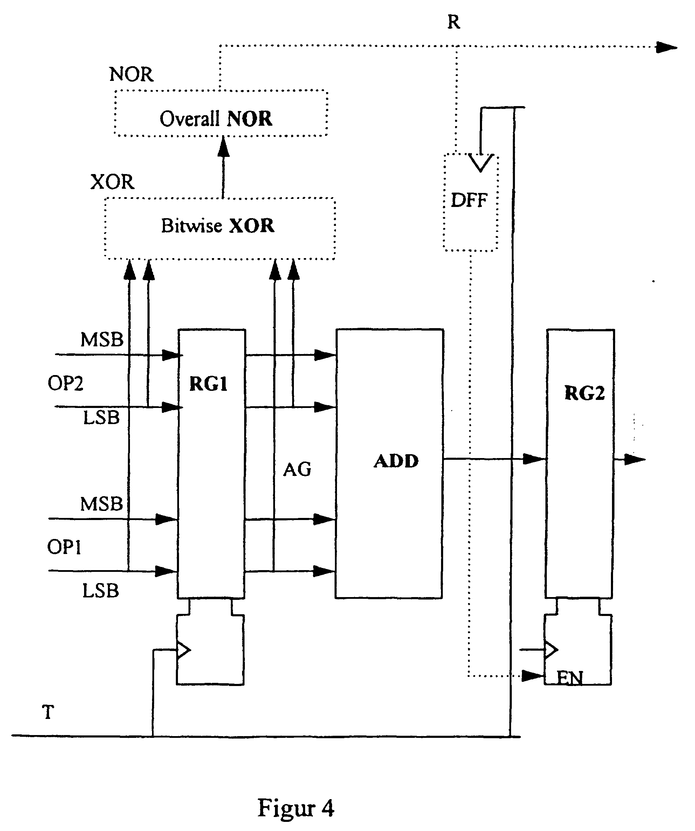

Die Erfindung wird anhand von Figur 3 und Figur 4 weiter erläutert.

Im folgenden wird mit Register immer ein getaktetes Speicherelement bezeichnet, unabhängig davon, ob es sich nur um eine Ausführung handelt, die nur ein Bit speichern (diese wird auch mit FlipFlop bezeichnet) oder mehrere Bits speichern kann. Ein Register bezeichnet hier auch nicht nur ein Speicherelement, das einen Eingangswert übernehmen sondern auch zusätzlich oder alternativ auch einen Wert setzen, rücksetzen (dies mit JK-FlipFlop bezeichnet) oder bedingt speichern (dies wird mit FlipFlop /Register mit Enable bezeichnet) kann. Des weiteren kann ein Register noch einen zusätzlichen asynchronen Setz- oder Rücksetzeingang besitzen.

Figur 3 illustriert die Erfindung. Die Eingangswerte E_RG1 und Ausgangswerte A_RG1 vom Eingangsregister RG1 werden (zumindest teilweise) in einer Vergleichseinheit COM verglichen. Damit kann festgestellt werden, ob und wo nach der nächsten Taktflanke des Taktsignales T ein Signalwertwechsel am Ausgang auftreten wird. Darauf aufbauend erzeugt die Steuerschaltung CON1 ein Signal R, mit dem das Laden des der kombinatorischen Schaltung KBL nachfolgenden Ausgangsregisters RG2 in Abhängigkeit von Signalwertwechseln gesteuert wird. Zusätzlich kann, wenn nötig, noch das Signal R aus der Steuerschaltung CON1 dazu verwendet werden, um anzugeben, wann oder nach wie vielen Zyklen ein neuer Wert an das Eingangsregister RG1 angelegt werden kann.

Figur 4 zeigt ein Anwendungsbeispiel der oben beschriebenen Erfindung auf einen Addierer ADD, der zwischen einem Eingangsregister RG1 und einem Ausgangsregister RG2 angeordnet ist. Das Eingangsregister RG1 hat zwei Vierbyte Eingänge OP1, OP2 und einen Vierbyte Ausgang AG. Der Addierer ADD sei rein kombinatorisch aufgebaut.

Die jeweils niederwertigeren zwei Byte (LSB genannt; die höherwertigen Byte sind mit MSB bezeichnet) der Operanden OP1 und OP2 am Eingang und am Ausgang des Eingangsregisters RG1 werden in einer XOR-Schaltung XOR bitweise XOR-verknüpft. Jeder Ausgang der XOR-Verknüpfung ist dann "1", wenn die Werte unterschiedlich sind, sonst sind sie "0". Über alle Ausgänge der XOR-Verknüpfung wird nun durch eine NOR-Schaltung NOR eine NOR Operation durchgeführt. Ist ein Ausgang der XOR-Verknüpfung gleich "1", d.h. an den unteren Bits ist ein Ereignis aufgetreten, dann ist der Ausgang "0". In dem Fall, in dem alle Ausgänge der XOR-Verknüpfung den Wert "0" haben, liegt am Ausgang der NOR-Operation eine "1" an.

Diese "1" wird dann zum einen in einer Schaltung DFF verzögert, um damit den Enable-Eingang EN des Ausgangsregisters RG2 auf "1" zu setzen, so daß mit dem nächsten Taktsignal T der Wert des Ausgangs des Addierers ADD im Ausgangsregister RG2 gespeichert werden kann. Zum anderen kann dieser Wert als Flag R ausgegeben werden, damit davon abhängig der Wert am Eingang des Eingangsregister RG1 noch einen weiteren Takt gehalten werden kann. In diesem Fall wird am Ausgang der NOR-Operation einen Takt später der Wert "1" erscheinen, und das Ergebnis einen Takt später in das Register RG2 eingetaktet werden.

## Patentansprüche

1. Schaltungsanordnung mit zwischen Registern (RG) angeordneten kombinatorischen Blöcken (KBL),
bei der der Eingang (E_RG1) und der Ausgang (A_RG1) des vor die kombinatorischen Blöcke (KBL) geschalteten Eingangsregisters (RG1) mit einer Vergleichseinheit (COM) verbunden ist, die den Wert am Eingang und am Ausgang des Eingangsregisters (RG1) vergleicht und bei Auftreten eines Signalwertwechsels am Eingang ein Steuersignal zum Laden des Ausgangswertes der kombinatorischen Blöcke (KBL) in das hinter die kombinatorischen Blöcke geschaltete Ausgangsregister (RG2) abgibt.

2. Schaltungsanordnung nach Anspruch 1,
bei der eine Steuerschaltung (CON1) vorgesehen ist, die bei Gleichheit des Wertes am Eingang und am Ausgang des Eingangsregisters (RG1) aus dem Steuersignal ein Übernahmesignal (R) für den Enable-Eingang des Ausgangsregisters (RG2) erzeugt, so daß dieses den Wert des Ausgangs der kombinatorischen Blöcke (KBL) mit dem nächsten Taktsignal (T) übernimmt.

3. Schaltungsanordnung nach Anspruch 1 oder 2,
bei der die kombinatorischen Blöcke (KBL) als Addierer (ADD) ausgeführt sind,
bei der die niederwertigen Byte (LSB) der dem Eingangsregister zugeführten Operanden (OP1, OP2) und die am Ausgang des Eingangsregisters (RG1) abgegebenen niederwertigen Byte der gespeicherten Operanden in der Vergleichseinheit (COM) verglichen werden und bei Gleichheit das Steuersignal erzeugt wird.

4. Schaltungsanordnung nach Anspruch 3,
bei der die Vergleichseinheit eine XOR-Schaltung ist.

5. Schaltungsanordnung nach Anspruch 3,
bei der Steuerschaltung (CON1) eine NOR-Schaltung ist.

6. Schaltungsanordnung nach einem der vorhergehenden Ansprüche,
bei der das Übernahmesignal (R) zur Freigabe dem Eingangsregister zugeführt wird.

## Claims

1. Circuit arrangement having combinatorial blocks (KBL) arranged between registers (RG),
in which the input (E_RG1) and the output (A_RG1) of the input register (RG1) connected upstream of the combinatorial blocks (KBL) are connected to a comparison unit (COM) which compares the value at the input and at the output of the input register (RG1) and, if a change of signal value appears at the input, outputs a control signal for loading the output value from the combinatorial blocks (KBL) into the output register (RG2) connected downstream of the combinatorial blocks.

2. Circuit arrangement according to Claim 1,
in which a control circuit (CON1) is provided which, in the event of the value at the input and at the output of the input register (RG1) being equal, takes the control signal and produces an acceptance signal (R) for the Enable input of the output register (RG2), so that the latter accepts the value from the output of the combinatorial blocks (KBL) upon the next clock signal (T).

3. Circuit arrangement according to Claim 1 or 2,
in which the combinatorial blocks (KBL) are in the form of adders (ADD),
in which the less-significant byte (LSB) of the operands (OP1, OP2) supplied to the input register and the less-significant byte of the stored operands, which is output at the output of the input register (RG1), are compared in the comparison unit (COM), and the control signal is produced if they are equal.

4. Circuit arrangement according to Claim 3,
in which the comparison unit is an XOR circuit.

5. Circuit arrangement according to Claim 3,
in which the control circuit (CON1) is a NOR circuit.

6. Circuit arrangement according to one of the preceding claims,
in which the acceptance signal (R) for enabling is supplied to the input register.

## Revendications

1. Circuit comprenant deux blocs (KBL) combinatoires disposés entre des registres (RG),
dans lequel l'entrée (E_RG1) et la sortie (A_RG1) du registre (RG1) d'entrée monté avant les blocs (KBL) combinatoires sont reliées à une unité (COM) de comparaison, qui compare la valeur à l'entrée et à la sortie du registre (RG1) d'entrée et, s'il se produit une inversion de la valeur du signal à l'entrée, émet un signal de commande pour le chargement de la valeur de sortie des blocs (KBL) combinatoires dans le registre (RG2) de sortie monté derrière les blocs combinatoires.

2. Circuit suivant la revendication 1,
dans lequel il est prévu un circuit (CON1) de commande qui, en cas d'égalité de la valeur à l'entrée et à la sortie du registre (RG1) d'entrée, produit, à partir du signal de commande, un signal (R) de prise en charge pour l'entrée de validation du registre (RG2) de sortie, de sorte que celui-ci prend en charge la valeur de la sortie des blocs (KBL) combinatoires avec le signal (T) d'horloge immédiatement suivant.

3. Circuit suivant la revendication 1 ou 2,
dans lequel les blocs (KBL) combinatoires sont réalisés en additionneur (ADD),
dans lequel les octets (LSB) les moins significatifs des opérandes (OP1, OP2) envoyés au registre d'entrée et les octets les moins significatifs, émis à la sortie du registre (RG1) d'entrée, des opérandes mémorisés sont comparés dans l'unité (COM) de comparaison et, en cas d'égalité, le signal de commande est produit.

4. Circuit suivant la revendication 3,
dans lequel l'unité de comparaison est un circuit XOR.

5. Circuit suivant la revendication 3,
dans lequel le circuit (CON1) de commande est un circuit NON OU.

6. Circuit suivant l'une des revendications précédentes,
dans lequel le signal (R) de prise en charge est envoyé pour la libération du registre d'entrée.
